# EUROPEAN PATENT SPECIFICATION

(11) **EP 4 231 335 B1**
(45) Date of publication and mention of the grant of the patent: **19.06.2024**
(21) Application number: 22156958.5
(22) Date of filing: 16.02.2022
(51) Int. Cl.: H01L 21/322, H01L 21/205

(54) **A HETEROEPITAXIAL WAFER FOR THE DEPOSITION OF GALLIUM NITRIDE**
HETEROEPITAKTISCHER WAFER ZUR ABSCHEIDUNG VON GALLIUMNITRID
TRANCHE HÉTÉROÉPITAXIALE POUR LE DÉPÔT DE NITRURE DE GALLIUM

(43) Date of publication of application: 23.08.2023
(73) Proprietor: Siltronic AG, 81677 München (DE)
(72) Inventor: Murphy, Brian, 84347 Pfarrkirchen (DE); Thapa, Sarad Bahadur, 84489 Burghausen (DE)

(56) References cited:
- DE-A1-102006 004 870
- US-A1- 2018 174 824

## Description

The present invention relates to a heteroepitaxial wafer that is optimized for depositing Gallium nitride on it.

### Description of the Related Art

Gallium nitride (GaN) offers some fundamental advantages over silicon. In particular, the higher critical electrical breakdown field makes it very attractive for power semiconductor devices with outstanding specific dynamic on-state resistance and smaller capacitances compared to silicon MOSFETs. So, GaN HEMTs are great for high speed switching. This is not only because of the resulting power savings and total system cost reduction, it also allows a higher operating frequency, improves the power density as well as the overall system efficiency.

DE 10 2006 004870 A1 discloses a heteroepitaxial wafer.

During growth of GaN p-n junction diodes using Metal- Organic Chemical Vapor Deposition (MOCVD), it is very difficult to grow a p-type material with good structural, optical and at the same time electrical integrity. The p-type region of a GaN junction diode is commonly grown in a MOCVD reactor by adding magnesium (Mg) to achieve the desired conductivity.

However, a common problem is the electrical passivation of acceptors like Mg, zinc (Zn), carbon (C) and others by hydrogen atoms. It is believed that Hydrogen atoms diffuse into the GaN material, where they neutralize the Mg acceptors and the holes produced by the Mg.

The passivation process leaves the Mg acceptors inactive, resulting in the material becoming insulating or weakly p-type in its as grown state. The passivation of the p-type region results in critical performance problems for the diode. Hydrogen passivation of acceptors and donors has been reported for a wide variety of semiconductors including silicon [see S.J. Pearton et. al., Appl. Phys. A 43, 153 (1987)], gallium arsenide [N.M. Johnson et. al., Phys. Rev. B 33, 1102 (1986); W.C Dautremont-Smith, Mater. Res. Soc. Symp. Proc. 104, 313 (1988)], indium phosphide [G.R. Antell et. al., Appl. Phys. Lett., 53, 758 (1988)], and cadmium telluride [L. Svob et. al., J. Cryst. Growth 86, 815 (1988)].

Passivation has been demonstrated both intentionally and unintentionally as a result of the epitaxial growth process. The growth of GaN diodes represents an example where hydrogen passivation plays an important role. It has been shown that passivation of acceptors occurs after growth, during the reactor cooling stage. [G.R. Antell et al., Appl. Phys. Lett. 73, 2953 (1998)]. Hydrogen is common in a MOCVD reactor during growth of the GaN material and subsequent reactor cooling, generally coming from two sources. Hydrogen is commonly used during growth as a carrier gas for the growth source gases.

In addition, ammonia (NH₃) is used as a source gas for nitrogen (N) during growth of the GaN material and is also used to stabilize the GaN material during reactor cooling. Hydrogen is produced as a by-product of the ammonia decomposition during growth and cooling. During a conventional GaN growth process, there is sufficient hydrogen available in the reactor to cause passivation of the p-type region during cooling.

Passivation of a p-type region could theoretically be avoided by removing the hydrogen source from the reactor prior to cool down as disclosed in US 5,891,790 A.

However, the GaN crystal is unstable at growth temperatures and the p-type GaN region is susceptible to decomposition which results in surface damage. The conventional method for avoiding this decomposition is to maintain the flow of NH₃ during reactor cooling.

However, the presence of NH₃ during reactor cooling produces hydrogen and leads to passivation. As such, it was thought that the removal of all hydrogen sources was not practical and that passivation during reactor cooling could not be avoided.

US 649 8111 B1 discloses methods of fabricating passivation-barrier layers to prevent or reduce doping species passivation during the semiconductor growth process, thus eliminating or at least reducing the effects described above.

It is advantageous to heteroepitaxially grow GaN layers onto a silicon substrate, both from a perspective substrate cost and for the potential to more closely integrate GaN-based devices with silicon-based devices.

Such GaN-on-silicon (GOS) growths are difficult, to produce because of both lattice mismatch and mismatch of the linear thermal expansion coefficient between the nitride material and silicon substrate.

During a high temperature process, such as epitaxial growth, thermal expansion mismatch can cause substrate bowing and warping. Bow is a measure of vertical displacement of the substrate surface and becomes more significant as the substrate diameter increases unless the silicon substrate thickness is increased significantly to provide the greater rigidity needed to resist larger thermal mismatch stress.

Silicon substrate diameters and thicknesses are standardized, however, with little concern for GOS applications.

As a result, high temperature GaN growth that induces a bow of around 300 µm in substrate having a diameter of 200 mm and a thickness of 725 µm may induce a bow of over 650 µm for a substrate having a diameter of 300 mm and a thickness of 775 µm which is not acceptable for modern device manufacturing processes.

It is also known that hydrogen has a rather high diffusion coefficient in silicon at high temperatures. Therefore, the quality of GaN layers deposited on a silicon substrate would be reduced by hydrogen, which can diffuse into the GaN layer via the substrate.

In this invention it is the task of the present invention to provide a substrate made of silicon that can be coated with doped GaN without causing described passivation effects of the dopant caused by hydrogen.

The solution is given by the features of the claims of this invention.

### Detailed Description

Although having some technical measures in place which are known in the prior art the inventors realized that diffusion of hydrogen in GaN is still a problem on Si wafers. This diffusion results in quality flaws especially concerning the dopant of the GaN. The inventors realized (without scientific proof) that the diffusion of hydrogen through the backside of the wafer (through silicon) is responsible for that.

Preferably, the improvement is achieved by a combination of layers that can prevent the diffusion through gettering, barriers and passivation/neutralization of the malign effects of hydrogen on dopants.

The granted patent document US 649 811 1 B1 teaches methods of fabricating passivation-barrier layers to prevent or reduce doping species passivation during the semiconductor growth process, thus eliminating the need for in-situ or ex-situ annealing steps. However, the inventors realized that the methods presented in the prior art are not sufficient to entirely solve the problem.

Preferably, a substrate that can be used of a for heteroepitaxial wafer comprises a silicon substrate which is oriented in <1-1-1> direction.

Preferably, the thickness of the substrate is more than 700 µm and less than 1100 µm.

Preferably the diameter of the substrate is more than 125 mm and less than 310 mm.

The resistivity of the silicon substrate layer depends on the power device application. In many power device applications conducting substrates are preferred. If electrical conducting substrates are required, the resistivity is preferably less than 10 mOhmcm. If RF HEMT devices semi-insulating or insulating substrates are required, resistivity is preferably higher than 1000 Ohmcm with a low Oᵢ concentration of preferably less than 2 x 10¹⁷ At/cm³. So, the resistivity of the silicon substrate preferably is less than 10 mOhmcm or more than 1000 Ohmcm.

The inventors further realized that it is most preferred to use a substrate having an interstitial oxygen content of less than 2 x 10¹⁷ At/cm³ (ASTM-Norm F121-83) and at the same time the resistivity of the silicon substrate is more than 1000 Ohmcm.

Preferably, the silicon substrate comprises an intermediate or buried gettering layer that is able to getter the diffusing species of hydrogen.

The gettering layer preferably comprises a stress field or implanted Helium or Oxygen layer to disturb the crystal and thus gettering the hydrogen species. More preferably the gettering layer comprises a "stable getterer". A "stable getterer" is understood as crystal defects that act as gettering centers for metals that maintain the gettering properties even after high temperature processing steps lasting up to 30 minutes at a temperature up to 1200°C.

As an example of the above mentioned stable getterer voids can be generated by Helium implantation in the crystal and those voids can be stabilized by co-implantation of Oxygen. It is understood that the implanted Oxygen atoms form silicon oxide on the surface of the the inner walls of the generated voids and thus stabilizes those voids.

To determine the efficiency of the gettering, a test can be carried out in the course of which the wafer to be tested is intentionally contaminated with metal ions on the back side ("Graff test"). The impurities are then driven into the crystal lattice by heating the semiconductor wafer. If no effective getter centers are present, they can reach the front side of the semiconductor wafer, where they can be detected by etching and by means of scattered light measurement (haze measurement). This test can be performed, for example, with impurities such as copper (Cu), iron (Fe), nickel (Ni) or palladium (Pd). This test is performed using metals as contaminants; however, the inventors came the conclusion that this test is valid for hydrogen, too.

The inventors understood (without scientific proof) that the end of range damage during the implantation process can create some getter centers for the hydrogen species. This measure is effective even at elevated temperatures which are common during the device manufacturing process. More preferably, the gettering layer comprises voids.

Preferably, the silicon substrate is covered by a 3C-SiC epitaxial layer. Even more preferably, the epitaxial layer is covered by a layer of Aluminum-Nitride.

The Aluminum-Nitride layer which is made by MOCVD comprises in the given order a first nitrogen enriched Aluminum-Nitride region, an Aluminum-Nitride region and a second nitrogen enriched Aluminum-Nitride region.

So, a region of the nitrogen enriched Aluminum-Nitride is preferably in contact with the 3C-SiC layer. This region is thought to act as a passivation layer.

## Claims

1. A heteroepitaxial wafer comprising in the following order
(1) a substrate made of Silicon having a thickness, a diameter and a resistivity comprising a buried gettering layer for Hydrogen,
(2) a 3C-SiC layer,
(3) an Aluminum-Nitride nucleation layer, comprising in the given order a first nitrogen enriched Aluminum-Nitride region, an Aluminum-Nitride region and a second nitrogen enriched Aluminum-Nitride region.

2. A heteroepitaxial wafer according to claim 1, **characterized in that** the gettering layer comprises voids.

3. A heteroepitaxial wafer according to claim 1, **characterized in that** the gettering layer comprises end of range damage.

4. A heteroepitaxial wafer according to claim 1, **characterized in that** the crystal orientation of the substrate is <1-1-1>.

5. A heteroepitaxial wafer according to claim 1, **characterized in that** the diameter is more than 125 mm and less than 310 mm.

6. A heteroepitaxial wafer according to claim 1, **characterized in that** the thickness is more than 700 µm and less than 1100 µm.

7. A heteroepitaxial wafer according to claim 1, **characterized in that** the resistivity of the silicon substrate is less than 10 mOhmcm.

8. A heteroepitaxial wafer according to claim 1, **characterized in that** the resistivity of the silicon substrate is more than 1000 Ohmcm.

9. A heteroepitaxial wafer according to claim 8, **characterized in that** the oxygen content of the silicon substrate is less than 2 x 10¹⁷ At/cm³ (ASTM-Norm F121-83).

## Patentansprüche

1. Heteroepitaxialer Wafer, in der folgenden Reihenfolge Folgendes umfassend
(1) ein Substrat, das aus Silizium angefertigt ist, mit einer Dicke, einem Durchmesser und einem spezifischen Widerstand, das eine vergrabene Getterschicht für Wasserstoff umfasst,
(2) eine 3C-SiC-Schicht,
(3) eine Aluminiumnitrid-Nukleationsschicht, die in der gegebenen Reihenfolge einen ersten mit Stickstoff angereicherten Aluminiumnitrid-Bereich, einen Aluminiumnitrid-Bereich und einen zweiten mit Stickstoff angereicherten Aluminiumnitrid-Bereich umfasst.

2. Heteroepitaxialer Wafer nach Anspruch 1, **dadurch gekennzeichnet, dass** die Getterschicht Leerstellen umfasst.

3. Heteroepitaxialer Wafer nach Anspruch 1, **dadurch gekennzeichnet, dass** die Getterschicht End-of-Range-Damage umfasst.

4. Heteroepitaxialer Wafer nach Anspruch 1, **dadurch gekennzeichnet, dass** die Kristallorientierung des Substrats <1-1-1> ist.

5. Heteroepitaxialer Wafer nach Anspruch 1, **dadurch gekennzeichnet, dass** der Durchmesser größer als 125 mm und kleiner als 310 mm ist.

6. Heteroepitaxialer Wafer nach Anspruch 1, **dadurch gekennzeichnet, dass** die Dicke größer als 700 µm und kleiner als 1100 µm ist.

7. Heteroepitaxialer Wafer nach Anspruch 1, **dadurch gekennzeichnet, dass** der spezifische Widerstand des Silizium-Substrats kleiner als 10 mOhmcm ist.

8. Heteroepitaxialer Wafer nach Anspruch 1, **dadurch gekennzeichnet, dass** der spezifische Widerstand des Silizium-Substrats größer als 1000 Ohmcm ist.

9. Heteroepitaxialer Wafer nach Anspruch 8, **dadurch gekennzeichnet, dass** der Sauerstoff-Gehalt des Silizium-Substrats kleiner ist als 2 x 10¹⁷ At/cm³ (ASTM-Norm F121-83) .

## Revendications

1. Plaquette hétéroépitaxiale comprenant dans l'ordre suivant
(1) un substrat composé de silicium ayant une épaisseur, un diamètre et une résistivité comprenant une couche de piégeage enfoncée pour de l'hydrogène,
(2) une couche de 3C-SiC,
(3) une couche de nucléation de nitrure d'aluminium, comprenant dans l'ordre donné une première zone de nitrure d'aluminium enrichi en azote, une zone de nitrure d'aluminium et une deuxième zone de nitrure d'aluminium enrichi en azote.

2. Plaquette hétéroépitaxiale selon la revendication 1, **caractérisée en ce que** la couche de piégeage comprend des cavités.

3. Plaquette hétéroépitaxiale selon la revendication 1, **caractérisée en ce que** la couche de piégeage comprend un dommage de fin de portée.

4. Plaquette hétéroépitaxiale selon la revendication 1, **caractérisée en ce que** l'orientation cristalline du substrat est de <1-1-1>.

5. Plaquette hétéroépitaxiale selon la revendication 1, **caractérisée en ce que** le diamètre est supérieur à 125 mm et inférieur à 310 mm.

6. Plaquette hétéroépitaxiale selon la revendication 1, **caractérisée en ce que** l'épaisseur est supérieure à 700 µm et inférieure à 1 100 µm.

7. Plaquette hétéroépitaxiale selon la revendication 1, **caractérisée en ce que** la résistivité du substrat de silicium est inférieure à 10 mOhmcm.

8. Plaquette hétéroépitaxiale selon la revendication 1, **caractérisée en ce que** la résistivité du substrat de silicium est supérieure à 1 000 Ohmcm.

9. Plaquette hétéroépitaxiale selon la revendication 8, **caractérisée en ce que** la teneur en oxygène du substrat de silicium est inférieure à 2 x 10¹⁷ at/cm³ (norme ASTM F 121-83).
